(19) Europäisches Patentamt
European Patent Office
Office européen des brevets

(11) **EP 3 893 011 B1**

(12) **EUROPEAN PATENT SPECIFICATION**

(45) Date of publication and mention
of the grant of the patent:
**27.12.2023 Bulletin 2023/52**

(21) Application number: **20215974.5**

(22) Date of filing: **21.12.2020**

(51) International Patent Classification (IPC):
**G01R 33/02** (2006.01)     **G01R 33/06** (2006.01)
**G01R 33/09** (2006.01)

(52) Cooperative Patent Classification (CPC):
**G01R 33/0206; G01R 33/063; G01R 33/093;**
G01R 33/0023

(54) **SCALAR MAGNETIC FIELD MEASURING PROBE**

SKALARE MAGNETFELDMESSSONDE

SONDE DE MESURE DE CHAMP MAGNÉTIQUE SCALAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.04.2020 LT 2020518**

(43) Date of publication of application:
**13.10.2021 Bulletin 2021/41**

(73) Proprietor: **Valstybinis moksliniu tyrimu institutas
Fiziniu ir
technologijos mokslu centras
02300 Vilnius (LT)**

(72) Inventors:
• **STANKEVIC, Voitech**
**07100 Vilnius (LT)**
• **BALEVICIUS, Saulius**
**07187 Vilnius (LT)**
• **ZURAUSKIENE, Nerija**
**08431 Vilnius (LT)**
• **SIMKEVICIUS, Ceslovas**
**06137 Vilnius (LT)**
• **KERSULIS, Skirmantas**
**03205 Vilnius (LT)**

(74) Representative: **Draugeliene, Virgina Adolfina
Tarpine Ltd
A. P. Kavoliuko g. 24-152
04328 Vilnius (LT)**

(56) References cited:
EP-A1- 2 040 088      EP-A1- 3 023 804
EP-B1- 2 040 088      EP-B1- 3 023 804
JP-A- S59 197 874    US-A1- 2005 122 100
US-A1- 2011 095 754  US-B1- 6 232 776

• **EGILMEZ M ET AL: "The anisotropic
magnetoresistance in epitaxial thin films and
polycrystalline samples of La0.65Ca0.35MnO3",
JOURNAL OF APPLIED PHYSICS, AMERICAN
INSTITUTE OF PHYSICS, US, vol. 105, no. 7, 3
February 2009 (2009-02-03), pages 7D706-7D706,
XP012124696, ISSN: 0021-8979, DOI:
10.1063/1.3056586**

## Description

Technical field

The invention relates to measuring equipment means for measuring a magnetic field. The invention can be used in measurement, control and monitoring systems in which a constant or variable scalar magnetic flux density (magnetic induction) is measured.

State of the art

A scalar magnetic field measuring probe ( see US 2005/122100 A1 ) comprising first and second magnetoresistive sensors, each having a respective dielectric substrate coated with a corresponding thin film nickel-iron (Permalloy) thin film deposited on a silicon wafer of a material whose electrical resistance varies depending on magnetic field and on the thin film of the each magnetoresistive sensor electrically conductive contact areas are locally formed, to which connecting wires are connected for connecting an electric current source wherein a third magnetoresistive sensor is provided, having a dielectric substrate coated with a thin film of a material whose electrical resistance varies depending on magnetic field (see above), and on the thin film of the third magnetoresistive sensor locally are formed electrically conductive contact areas to which connecting wires are connected for the connection of the electric current source (see above), and all three said magnetoresistive sensors are arranged so that the plane of the thin film of each of said magnetoresistive sensors is perpendicular to the planes of the other two sensors.

Its disadvantage is that the Permalloy based sensors can not be applied for high magnetic field (more than Tesla) measurements because usually the magnetoresistive properties saturates in the range from 0.002T- to 0.5T. Moreover, such design of magnetic field measurements probe consisting of three sensors having independent supply and signal processing circuits is not able to be used for high frequency (higher than 10kHz) measurement due to high level of interference generated in connecting wires and high inductance of the sensor's node.

Another design of the scalar magnetic field measurement probe is suggested in JP S59 197874 A. According to this invention the accurate detection of a scalar amount is obtained as a sum of magnetic fields in three ortogonal directions. It discloses 3 magnetic sensors having an orthogonal relationship with each other connected in series. Each sensor consist of ferromagnetic core unrolled by coil which measures the inductance such coil-ferromagnetic core system. Application of magnetic field changes the magnetization of the core thus the electrocal signal generated in the coil is proportional to the external magnetic field value. However, as in case of invention US 2005/122100 A1, the probe is able to measure low (up to 0.5T) magnetic field due to saturation of conventional bulk feromagnetic materials. Another disadvantages of such sensor are relatively large (several cm$^3$) volume and four terminals (two wires for sensor's supply and two for inductance measurement). This means that it could not be used for acurate measurents of magnetic field which gradient is in milimeters scale and pulsed magnetic field measurement frequency range due to large parazitic electromotive voltages is no more than 1kHz.

EP3023804A1 discloses an induction measuring device with a substrate coated with thin polycrystalline material that can be polycrystalline lanthanum-calcium-manganese oxide.

Resistive magnetic field sensors are known in which the sensitive element is a resistor whose resistance varies with the strength of the magnetic field
and does not depend on the direction of the magnetic
field in the plane of the sensitive element (see U.S. Patent No. 6,232,776). Its disadvantage is that the resistance of the sensor depends on the direction of the magnetic field when the field is not oriented in the plane of the sensing element, but forms a certain angle with it, resulting in large measurement errors if the direction of the magnetic field is not known.

The closest to the proposed solution is a scalar magnetic field probe that measures the modulus of magnetic flux density (magnetic induction) regardless of direction. It consists of two magnetoresistive sensors, made fom CMR) material, both of which have different resistances depending on the strength of the magnetic field, but their dependencies of resistance and the magnetoresistance on temperature are different (see EU Patent No. 2040088). The sensors consist of polycrystalline and monocrystalline thin films of manganite deposited on an insulating substrate in parallel planes and four metal contact pads to which the wires are connected. By connecting these two magnetoresistive sensors in series, the temperature dependence of their total resistance and magnetoresistance can be reduced. The disadvantages of this magnetic field probe, are that the independence from the direction of the magnetic field is not fully guaranteed: i.e. a certain dependence of the change of the total resistance of the probe on the direction of the magnetic field is observed when same magnetic field acts to the probe, especially when the direction of the magnetic field is not parallel to the plane of the thin films.

Technical problem to be solved

The aim of the present invention is to reduce the anisotropy of the magnetoresistance of a scalar magnetic field measuring probe, i.e. to improve the accuracy of measurements if measurements are made when the direction of the magnetic field is not known.

Disclosure of the essence of the invention

The essence of the invention is achieved by the scalar magnetic field measuring probe according to claim 1.

Advantages of the invention

The proposed magnetic field probe is small in size and can therefore measure magnetic induction in small volumes. Because the probe is equipped with three mutually perpendicular magnetoresistive sensors, the probe is not sensitive to changes in the direction of the magnetic field and measures the scalar value of magnetic induction.
More detailed description of the invention is given in the drawings, which do not limit the scope of the present invention:

Fig.1 shows a block diagram of a magnetic field probe.
Fig.2 shows the dependence of the magnetoresistance of one magnetoresistive sensor on the angle between the plane of the sensitive film and the direction of the magnetic field and the dependence of the magnetoresistance of three electrically connected sensors mounted perpendicular to each other on said angle.

An example of an embodiment of the invention

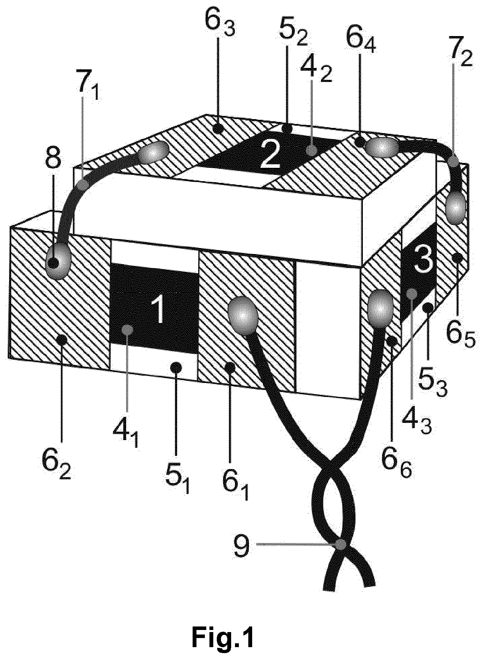

Fig. 1 shows a block diagram of a magnetic field probe. The probe consists of three magnetoresistive sensors 1, 2 and 3, in each of which a thin film of manganite sensitive to the magnetic field is formed ($4_1, 4_2, 4_3$). The resistance of this film decreases with increasing of the magnetic field. This film is grown on each of the sensors (1, 2, 3) on a corresponding substrate ($5_1, 5_2, 5_3$) made of an insulating material (dielectric substrate). A film of metal was evaporated over each manganite thin film ($4_1, 4_2, 4_3$) and corresponding contact areas ($6_1 - 6_6$) were formed. The first sensor 1 is connected to the second sensor 2 by means of a wire $7_1$ which is soldered with solder 8 to the contact pad. In the same way, the second sensor 2 is connected to the third sensor 3 by means of a wire $7_2$. Terminals 9 consisting of two bifilarly wounded connecting wires are connected to the free contact areas of the first and third sensors.
The reduction of magnetic resistance anisotropy in the proposed probe is explained as follows. A sensor that consists of only one element i.e. thin manganite film strips grown on a dielectric substrate and having thin film metal electrodes (contact pads) at both ends are characterized by two types of magnetoresistive anisotropy (*MRA*). *MRA* is calculated as the ratio of the maximum magnetoresistance difference, which varies with the angle between the magnetic field and the film plane, to the maximum magnetoresistance. The first *MRA* occurs when the magnetic field is in the plane of the substrate and the film and is associated with anisotropy due to the crystalline film structure and due to the mismatch between the current and the direction of the magnetic field. The second magnetoresistance anisotropy is related to the effect of demagnetization in thin films (shape anisotropy) when the magnetic field forms an angle with the film plane. In thin manganite films, the first *MRA* is significantly lower than the magnetoresistance anisotropy due to the shape effect. In the general case, the magnetoresistance (absolute value) of a probe consisting of only one sensor, depending on the angle between the magnetic field and the plane of the film, is equal to:

$$MR_1(\theta) = MR_{\parallel} + (MR_{\perp} - MR_{\parallel}) \cdot f(\theta); \qquad (1)$$

where $MR_{\parallel}$ is the magnetoresistance (absolute value) when the direction of the magnetic field (8) is parallel to the plane of the film, $MR_{\perp}$ is the magnetoresistance (absolute value) when the direction of *B* is perpendicular to the plane of the film, f $(\theta)$ is a dimensionless function, where $\theta$ is the angle formed by the vector of the magnetic field with the plane of the film. The function f $(\theta)$ in the case of epitaxial films is equal to $\sin^2\theta$, and in the case of polycrystalline films it can be a complicated expression: $1/(1+K) \cdot [\sin^2\theta + K \cdot (1-|\cos\theta|)]$, where *K* is a constant belonging from the chemical composition and morphology of the film.
In the case of epitaxial films, $MR_1(\theta) = MR_{\parallel} + (MR_{\perp} - MR_{\parallel}) \cdot \sin^2\theta$ and, as the angle between the magnetic field and the film plane changes from 0 to $\pi / 2$, the magnetic resistance changes from $MR_{\parallel}$ to $MR_{\perp}$. When three identical sensors from epitaxial films are connected in perpendicular planes to each other in a series connection circuit, the total magnetic resistance $MR_{3e}(\alpha, \beta, \gamma)$ is equal to:

$$MR_{3e}(\alpha, \beta, \gamma) = MR_\parallel + (MR_\perp - MR_\parallel) \cdot ( \sin^2\alpha + \sin^2\beta + \sin^2\gamma) = MR_\perp; \quad (2)$$

where $\alpha$, $\beta$, and $\gamma$ are angles formed by a magnetic field with three orthogonal planes. Since according to the known theorem $\sin^2\alpha + \sin^2\beta + \sin^2\gamma = 1$, then $MR_{3e}(\alpha, \beta, \gamma) = MR_\perp$. This means that in this case the representative magnetoresistance does not depend on the direction of the magnetic field and its anisotropy is 0. Therefore, in this case the response of the sensor does not depend on the direction of the magnetic field, but only on the value of this field.

When 3 polycrystalline films are joined in the same way, the representative magnetic resistance is equal to:

$$MR_{3p}(\alpha, \beta, \gamma) = MR_\parallel + [(MR_\perp - MR_\parallel)/3(1+K)]\cdot[1 + K\cdot(3-|\cos\alpha|-|\cos\beta|-|\cos\gamma|)]. \ (3)$$

In this case, the anisotropy of the magnetoresistance will depend on the value of the coefficient $K$ and will be maximal when the direction of the vector of the magnetic field ($B$) changes from the orientation corresponding to $\alpha = 0$; $\beta = 0$; $\gamma = \pi / 2$ (magnetic field perpendicular to one of the planes) to the orientation when the direction B is parallel to the diagonal of the orthogonal system, i.e. $\alpha = \beta = \gamma = 35,27^0$.

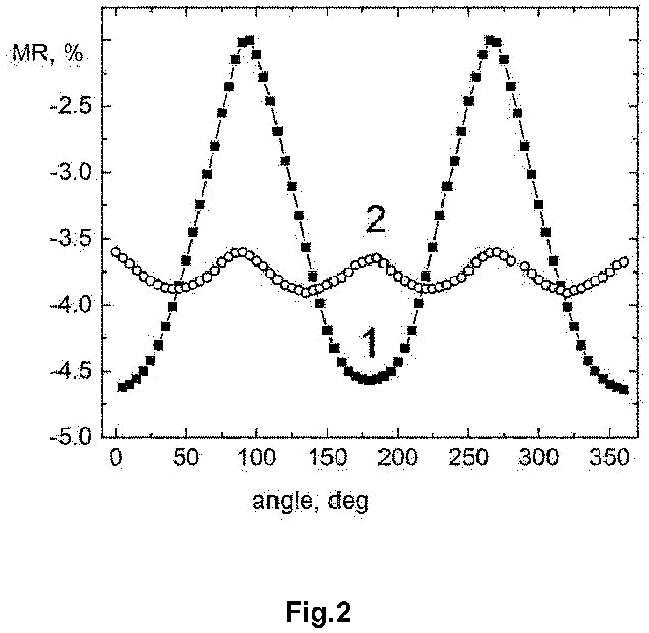

From the experimental measurements (see Fig. 2, curve 1) it was determined that the magnetic resistance of the probe from one polycrystalline sensor under the action of 0.7 T magnetic field is $I\ MR\parallel | = 4,63\%$ when the field is parallel to the plane of the sensor, and $|MR_\perp| = 1,98\%$ when the magnetic field is perpendicular to the plane. It was also found that the magnetoresistance of such a polycrystalline sensor as a function of the angle between the direction of the magnetic field and the plane of the film is well described using the formula:

$$MR_{1p}(\alpha) = MR_\parallel + [(MR_\perp - MR_\parallel)/(1+K)]\cdot[1 + K\cdot(1-|\cos\alpha|)], \quad (4)$$

when $K = 2,617$; $|MR_\parallel| = 4,63\ \%$; $|MR_\perp| = 1,98\ \%$.

Using these data, the magnetoresistance anisotropy ($MRA$) of such a sensor was calculated when the magnetic field was directed parallel and perpendicular to the plane of the film.

This anisotropy was equal to $100\%\cdot|(MR_\perp - MR_\parallel)/MR_\parallel| = 100\%\cdot(2,65/4,63) = 57,2\ \%$. Using formula (3), the magnetoresistance and its anisotropy were calculated when three identical sensors were orthogonally connected. The maximum difference in magnetic resistance (anisotropy) is obtained when the magnetic field is directed perpendicular to the plane of one of the sensors (i.e., $\alpha = 0$; $\beta = 0$; $\gamma = \pi / 2$), then $|MR_{3p}(0, 0, \pi/2)| = 3,7\%$ and when the magnetic field is directed along the diagonal of the coordinate system (i.e. $\alpha = \beta = \gamma = 35,27°$), then $|MR_{3p}(35,27^0, 35,27°, 35,27^0)| = 4,03\ \%$. In this case, the maximum anisotropy is equal to $100\% \cdot (0.33 / 4.03) = 8.19\%$. In this way, using the proposed design consisting of three sensors, it is possible to reduce the magnetoresistance anisotropy of the magnetic probe by at least $57.2 / 8.19 = 6.98$ times compared to a single sensor probe.

As an intermediate case, anisotropy can be calculated when the magnetic field is directed perpendicular to the plane of one of the sensors (i.e., $\alpha = 0$; $\beta = 0$; $\gamma = \pi / 2$) and when $\alpha = 0$; $\beta = \pi / 4$; $\gamma = \pi / 4$. In this case $|MR_{3p}(0, \pi/4, \pi/4)| = 4,01\ \%$, and anisotropy equal to $100\% (0.31 / 4.01) = 7.73\%$. Thus, the anisotropy of the magnetoresistance of a three-sensor probe is $57.2 / 7.73 = 7.41$ times lower than in the case of a probe consisting of one sensor.

The functioning of the proposed device was verified by forming the probe in such way. A thin 400 nm thickness polycrystalline $La_{0.83}Sr_{0.17}MnO_3$ film 4 was deposited to the dielectric polycrystalline $Al_2O_3$ substrate 5 (see Fig. 1) by pulsed injection vapor deposition of metalorganic compounds (PI MOCVD). Silver contact pads 5 of 1 $\mu m$ thickness were deposited on the film by thermal evaporation. The substrate with manganite film and contact pads was divided into 1x0.5x0.25 mm$^3$ magnetoresistive sensors by using of a diamond disk. Silver wires 7 and insulated twisted pair connecting wires 9 were connected to the contact points. Lead-silver (75% - 25%) solder 8 was used to connect the wires and twisted pair. Twisted pair wires 9 were used to eliminate the induced electromotive force in the wires of a magnetoresistive sensor under the action of a variable magnetic field. The magnetoresistive sensors connected in this way were coated with polyurethane sealing filler (not shown in Fig. 1). The resistance of the individual magnetoresistive sensors manufactured in such way at room temperature in the absence of a magnetic field was about 3.3 k$\Omega$, and when they were connected as shown in Fig. 1, the resistance of the entire formed probe was about 10 k$\Omega$.

The mounted magnetoresistive sensors (1, 2, 3) were tested by measuring the dependence of the resistance on the magnetic field at different sensor orientations with respect to the magnetic field. In Fig. 2 it is shown the dependence of the magnetoresistance ($MR$) of a single magnetoresistive sensor on the angle between the plane of the sensor sensitive film and the direction of the magnetic field (curve 1) at 290 K. The sensor was mounted on a holder of the closed-loop helium cryostat. The cryostat was used to maintain a stable temperature. The holder was fixed between the poles of the electromagnet. During the measurement of this dependence, a fixed magnetic field of 0.7 T and a fixed temperature of 290 K were maintained. We see that the value of this magnetoresistance ranged from -4.63% at angles of 0° and 180° to -1.98% at angles of 90° and 270°. Thus, the anisotropy (MRA) of magnetoresistance (*MRA*) was 100%·|[-4,63-(-1,98)]/(-4.63)| = 57,2 %, what indicates that the maximum measurement error due to the change in the direction of the magnetic field is 57.2 / 2 = 28.6%. Analogous magnetoresistance dependences on the angle were obtained by measuring the other two magnetoresistive sensors also.

These sensors were then mounted as shown in Fig. 1 and electrically connected in series. The resulting probe was tested analogously as the individual magnetoresistive sensors. In the same Fig. 2 the dependence of the magnetic resistance of the proposed magnetic field probe, consisting of three magnetoresistive sensors mounted perpendicular to each other and electrically connected in series, is shown also. In this case, the 0.7 T magnetic field was rotated so that it was constantly parallel to one of the sensor surfaces, and with respect to other sensors the angle between the surface and the field was changed from 0° to 360° ($\alpha = 0$; $\beta = 0 \div 2\pi$; $\gamma = \pi / 2 \div 5\pi / 2$) (see Fig. 2, curve 2). We see that the values of the magnetoresistance vary from -3.59% to -3.87%. In this case, the minimum and maximum magnetoresistance values are observed at different angles than in the case of individual magnetoresistance sensors, it is, at angles 45° and 90° and further every 45°. After calculation we get *MRA* = 7.23%, which means that the maximum measurement error due to the change in the direction of the magnetic field does not exceed 3.7%. Thus, the proposed magnetic field probe makes it possible to reduce the anisotropy of the magnetoresistance and thus the maximum measurement error by about 57.2 / 7.23 = 7.91 times compared to the measurement error of one sensor due to anisotropy. Thus, approximately a similar anisotropy reduction value is observed as expected in theoretical calculations.

If magnetic field measurements are performed at lower than room temperatures, it is advisable to use, for example, polycrystalline lanthanum-calcium-manganese oxide (La-Ca-Mn-O) films or lanthanum-strontium-manganese-cobalt oxide (La-Sr-Mn-Co-O) films instead of polycrystalline lanthanum-strontium-manganese oxide films. The latter films have similar values of magnetoresistance anisotropy, but their resistance has a minimum temperature variation range at lower temperatures.

## Claims

1.  A scalar magnetic field measuring probe comprising three magnetoresistive sensors (1, 2, 3), each having a respective dielectric substrate coated with a thin film of a material whose electrical resistance varies depending on a magnetic field, and on the thin film of the each magnetoresistive sensor locally are formed electrically conductive contact areas, to which connecting wires are connected for the connection of an electric current source, all three said magnetoresistive sensors (1, 2, 3) are arranged so that the plane of the thin film of each of said magnetoresistive sensors is perpendicular to the planes of the other two sensors and the probe is coated with a sealing filler, wherein the respective conductive contact areas and the connecting wires of said three magnetoresistive sensors (1, 2, 3) are interconnected in such a way to connect in series the thin films of all three said magnetoresistive sensors (1, 2, 3) to form a total probe resistance equal to a sum of the resistances of the individual said sensors (1, 2, 3) and that the material of the thin films, the electrical resistance of which varies depending on the magnetic field, is polycrystalline lanthanum-strontium-manganese oxide or polycrystalline lanthanum-calcium-manganese oxide or polycrystalline lanthanum-strontium-manganese-cobalt oxide.

## Patentansprüche

1.  Skalare Magnetfeld-Messsonde mit drei magnetoresistiven Sensoren (1, 2, 3), von denen jeder ein dielektrisches Substrat aufweist, das mit einem dünnen Film aus einem Material beschichtet ist, dessen elektrischer Widerstand in Abhängigkeit von einem Magnetfeld variiert, wobei auf dem dünnen Film jedes magnetoresistiven Sensors lokal elektrisch leitende Kontaktflächen vorgesehen sind, an die Verbindungsdrähte zum Anschluss einer elektrischen Stromquelle angeschlossen sind, wobei alle drei magnetoresistiven Sensoren (1, 2, 3) so angeordnet sind, dass die Ebene des dünnen Films jedes magnetoresistiven Sensors senkrecht zu den Ebenen der anderen beiden Sensoren verläuft und die Sonde mit einem dichtenden Füllstoff beschichtet ist, wobei die jeweiligen leitenden Kontaktflächen und die Verbindungsdrähte der drei magnetoresistiven Sensoren (1, 2, 3) so miteinander verbunden sind, dass die dünnen Filme aller drei magnetoresistiven Sensoren (1, 2, 3) in Reihe geschaltet sind, um einen Gesamt-Sondenwiderstand zu ergeben, der einer Summe der Widerstände der einzelnen Sensoren (1, 2, 3) entspricht, und dass es sich bei dem Material der dünnen Filme, deren elektrischer Widerstand in Abhängigkeit vom Magnetfeld variiert, um polykristallines Lanthan-Strontium-Mangan-Oxid oder polykristallines Lanthan-Calcium-Mangan-Oxid oder polykristallines Lanthan-Strontium-Mangan-Cobalt-Oxid handelt.

**Revendications**

1. Sonde de mesure de champ magnétique scalaire comprenant trois capteurs magnétorésistifs (1, 2, 3) ayant chacun son propre substrat diélectrique recouvert d'une mince couche d'un matériau dont la résistance électrique varie en fonction d'un champ magnétique, et sur la couche mince de chaque capteur magnétorésistif sont formées localement des zones de contact électriquement conductrices, auxquelles sont connectés des fils de connexion pour la connexion d'une source de courant électrique, les trois capteurs magnétorésistifs (1, 2, 3) étant disposés de telle sorte que le plan de la couche mince de chacun de ces capteurs magnétorésistifs est perpendiculaire aux plans des deux autres capteurs et que la sonde est recouverte d'un mastic d'étanchéité, dans lequel les surfaces de contact conductrices respectives et les fils de connexion de ces trois capteurs magnétorésistifs (1, 2, 3) sont interconnectés de manière à connecter en série les films minces des trois capteurs magnétorésistifs (1, 2, 3) pour former une résistance totale de la sonde égale à la somme des résistances de chacun de ces capteurs (1, 2, 3) et que le matériau des couches minces, dont la résistance électrique varie en fonction du champ magnétique, est de l'oxyde de lanthane-strontium-manganèse polycristallin ou de l'oxyde de lanthane-calcium-manganèse polycristallin ou de l'oxyde de lanthane-strontium-manganèse-cobalt polycristallin.

**Fig.1**

**Fig.2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005122100 A1
- JP S59197874 A
- EP 3023804 A1
- US 6232776 B
- WO 2040088 A